Europäisches Patentamt

European Patent Office

Office européen des brevets

(11) Veröffentlichungsnummer: **0 427 193 A2**

(12) **EUROPÄISCHE PATENTANMELDUNG**

(21) Anmeldenummer: 90121199.5

(22) Anmeldetag: 06.11.90

(51) Int. Cl.5: **G03F 7/00, G03F 7/26,** **G02F 1/133, H05K 3/06**

(30) Priorität: 10.11.89 DE 3937442

(43) Veröffentlichungstag der Anmeldung: 15.05.91 Patentblatt 91/20

(84) Benannte Vertragsstaaten: **DE FR GB IT NL**

(71) Anmelder: **Nokia Unterhaltungselektronik (Deutschland) GmbH** **Östliche Karl-Friedrich-Strasse 132** **W-7530 Pforzheim(DE)**

(72) Erfinder: **Barnaba, Martin** **Enzstrasse 41** **W-7000 Stuttgart-50(DE)** Erfinder: **Brosig, Stefan, Dr.** **Teckstrasse 51 B** **W-7000 Stuttgart-1(DE)** Erfinder: **Stoitzner, Monika** **Ottilie-Wildermuth-Strasse 7** **W-7440 Nürtingen(DE)** Erfinder: **Thaler, Helmut** **Limburgstrasse 97** **W-7319 Dettingen(DE)** Erfinder: **Waldmann, Jürgen, Dr.** **Leipziger Strasse 26** **W-7036 Schönaich(DE)**

(54) **Verfahren zum bereichsweisen Entfernen von Schichten von einem Substrat.**

(57) Es hat sich herausgestellt, daß zum bereichsweisen Entfernen von Schichten von einem Substrat eine Ultraschall-Badbehandlung besonders geeignet ist. Relativ hohe Ultraschallintensität kann dann angewendet werden, wenn eine Schicht nur entlang einem Rand eines Substrates zu entfernen ist. Dann wird das Substrat nur mit diesem Rand in die Badflüssigkeit eingetaucht, wobei es dicht oberhalb der Eintauchstelle gedämpft gehalten wird. Werden dagegen Schichten gemäß Strukturen entfernt, die sich vom Rand bis ins Innere einer Substratfläche erstrecken, muß verhältnismäßig geringe Ultraschallintensität eingesetzt werden. Um solche einzustellen, wurden handelsübliche Ultraschallbäder mit Gummimatten ausgelegt.

Wenn Schichten in Bereichen zu entfernen sind, die nicht durch Fotolackstreifen abgedeckt sind, ist es von Vorteil, als Ätzflüssigkeit eine solche mit möglichst hoher Viskosität zu verwenden. Zur Viskositätserhöhung eignet sich insbesondere Phosphorsäure. Zum Erhöhen der Ätzgeschwindigkeit von ITO ist es von Vorteil, der Ätzflüssigkeit einen Komplexbildner für Indium und Zinn beizusetzen. Hierzu eignen sich insbesondere Chloridionen.

Die Verfahren lassen sich insbesondere auf Schichten von Flüssigkristallzellensubstraten und auf Kupferschichten von Leiterplatten anwenden.

## VERFAHREN ZUM BEREICHSWEISEN ENTFERNEN VON SCHICHTEN VON EINEM SUBSTRAT

### TECHNISCHES GEBIET

Die Erfindung betrifft ein Verfahren zum Entfernen von Schichten von einem Substrat. Es kommen hier unterschiedlichste Schichten in Frage, bei Flüssigkristallzellensubstraten z. B. unelastische Schichten wie Barriereschichten aus $SiO_2$ gegen $Na^+$ Diffusion oder TFT-Schichten aus $Ta_2O_5$, oder elastische Schichten wie Fotolackschichten oder Orientierungsschichten z. B. aus Polyimid oder Polyphenylen, oder Kupferschichten bei Leiterplatten.

### STAND DER TECHNIK

Zum Entfernen von Schichten von einem Substrat, sei es für eine Flüssigkristallzelle, sei es für Leiterplatten, wird bisher das Sprühverfahren verwendet, bei dem ein Lösungsmittel auf das Substrat mit der zu entfernenden Schicht gesprüht wird. Zum Entfernen von $SiO_2$ wird Flußsäure verwendet, Positivfotolacke werden mit alkalischen Lösungen entwickelt und zum Entfernen von Orientierungsschichten in nicht gehärtetem Zustand werden in der Regel organische Lösungsmittel verwendet, z. B. Aceton oder Cyclopentanon. Zum Entfernen gehärteter Orientierungsschichten wird z. B. Trichlorethan verwendet. Kupferschichten werden durch Aufsprühen wässriger Natriumpersulfatlösungen abgelöst.

Bei all diesen Verfahren besteht das Bestreben, sie laufend so weiter zu verbessern, daß weniger Lösungsmittel eingesetzt werden muß und das Verfahren schneller abläuft. Außerdem ist nachteilig, daß die großindustriell eingesetzten Sprüheinrichtungen sehr teuer und störanfällig sind.

### DARSTELLUNG DER ERFINDUNG

Das erfindungsgemäße Verfahren· zum Entfernen von Schichten von einem Substrat zeichnet sich dadurch aus, daß das Substrat mit den zu entfernenden Schichtbereichen der Behandlung in einem Ultraschallbad solcher Intensität ausgesetzt wird, daß nur die zu entfernende Schicht angegriffen wird.

Bekanntlich ist es eine Hauptaufgabe von Ultraschallbehandlungen, unerwünschte Substanzen von Oberflächen von Gegenständen zu entfernen. Beim Herstellen von Flüssigkristallzellen oder Leiterplatten werden Ultraschallbäder grundsätzlich verwendet, um Substratplatten zu Beginn des Bearbeitungsprozesses zu reinigen. Es hat sich jedoch herausgestellt, daß die üblichen Ultraschall-Behandlungsverfahren nicht eingesetzt werden können, wenn Schichten, die im Herstellablauf aufgebracht werden, gezielt bereichsweise wieder entfernt werden sollen. Hier führt die Ultraschallenergie dann, wenn nicht die Zusatzbedingung gemäß der Erfindung beachtet wird, dazu, daß auch Schichtbereiche angegriffen werden, die eigentlich unverändert beibehalten werden sollen.

Für das teilweise Entfernen von Schichten von einem Substrat bestehen zwei unterschiedliche Problemstellungen. Die eine ist die, daß eine Schicht in einem Randbereich ganz entfernt werden soll, z. B. eine $SiO_2$-Barriereschicht auf den Anschlußkontakten einer Flüssigkristallzelle. Die andere Problemstellung geht dahin, eine Schicht zu strukturieren, also nur bestimmte Schichtbereiche zu entfernen, die sich nicht nur entlang dem Rand des Substrates, sondern bis ins Substratinnere erstrecken. Hierbei ist insbesondere an das Entfernen von Fotolackbahnen und das Ausätzen von Leiterschichtbahnen zu denken. ·

Ist eine Schicht nur in Randbereichen eines Substrates zu entfernen, ist es von Vorteil, das Substrat mit einem jeweiligen Rand in das Behandlungsbad einzutauchen und das Substrat im übrigen möglichst gedämpft zu haltern. In diesem Fall kann relativ hohe Ultraschallintensität angewendet werden, da nur der freie, nicht bedämpfte Rand der vollen Ultraschallenergie ausgesetzt ist. Sind dagegen nicht nur am Rand eines Substrats verlaufende Schichtbereiche zu entfernen, muß eine Ultraschallintensität verwendet werden, die erheblich unter der liegt, wie sie üblicherweise zum Reinigen von Oberflächen eingesetzt wird. Da bei marktüblichen Ultraschallbädern die einstellbare Minimalenergie noch zu hoch ist, um Schichten von einem Substrat für eine Flüssigkristallzelle gezielt strukturiert entfernen zu können, wurden auf den Boden marktüblicher Badanordnungen, also dorthin, wo die Ultraschallquellen angeordnet sind, Gummimatten gelegt. Dadurch ließ sich die Ultraschallenergie auf ein ausreichend niedriges Maß absenken.

Handelt es sich bei der zu entfernenden Schicht um eine zu strukturierende ITO-Schicht, ist es von besonderem Vorteil, als Entwicklungsflüssigkeit eine solche zu verwenden, die Komplexbildner für Indium und Zinn, insbesondere Chloridionen enthält. Bei Verwenden einer konzentrierten Kalziumchloridlösung mit 5 % Salzsäure ließ sich die Ätzgeschwindigkeit gegenüber derjenigen Zeit auf ein Viertel verkürzen, die beim Verwenden einer 18 %igen Salzsäurelösung erforderlich ist. Diese erhebliche Zeitverkürzung ist insbesondere bei einer Ultraschallbehandlung erzielbar, jedoch ergibt sich auch bei herkömmlichen Sprühverfahren eine erhebliche Beschleunigung, wenn mit einer Lösung mit Komplexbildner gesprüht wird.

Besonders saubere Ränder lassen sich beim Ätzen von Leiterbahnen dann erzielen, wenn die Ätzlösung ein viskositätserhöhendes Mittel, z. B. Phosphorsäure zum Ätzen von ITO enthält. Der Effekt macht sich wiederum insbesondere beim Anwenden von Ultraschall bemerkbar, wirkt sich aber auch bei herkömmlichen Sprühverfahren aus. Das Anwenden von Komplexbildnern für Indium und Zinn und/oder das Verwenden eines viskositätserhöhenden Mittels beim Ätzen von Leiterbahnen ist also nicht auf den Einsatz bei einer Ultraschallbehandlung begrenzt.

WEGE ZUM AUSFÜHREN DER ERFINDUNG

Beispiel 1:

Bei einer fertigen Flüssigkristallzelle wurden die mit einer $SiO_2$-Barriereschicht und einer Polyimid-Orientierungsschicht abgedeckten strukturierten Anschlußkontakte entlang dem Rand eines der Substrate der Zelle freigelegt. Hierzu wurde die Zelle so weit in ein Trichlorethan-Ultraschallbad getaucht, daß sich gerade die freizulegenden Kontaktbereiche im Bad befanden. Direkt oberhalb der Eintauchstelle wurde die Zelle mit Hilfe einer Gummiklammer gehalten. Es wurde dann für einige Minuten Ultraschall üblicher Frequenz und Intensität angewendet. Dabei wurde die Polyimidschicht durch das Trichlorethan gelöst. Die unelastische $SiO_2$-Schicht, die herkömmlicherweise mit Flußsäure abgeätzt wird, sprang in Stücken ab, wurde also mechanisch durch die Ultraschalleinwirkung entfernt.

Wie ersichtlich, war zum Entfernen der beiden Schichten nur ein einziger Arbeitsgang erforderlich, und insbesondere konnte das Einsetzen von Flußsäure vermieden werden. Beim Ausführen des Verfahrens war lediglich darauf zu achten, daß die Zelle ausreichend dicht über der Eintauchstelle gehalten wurde. Wurde die Zelle an demjenigen Rand gehalten, der zum eingetauchten Rand parallel lag, kam es auch im Zellinneren zum teilweisen Ablösen von Schichten.

Es wird darauf hingewiesen, daß beim Anwenden von starkem Ultraschall zum Entfernen einer nicht gehärteten Orientierungsschicht nicht nur die üblichen organischen Lösungsmittel eingesetzt werden können, sondern daß in diesem Fall auch eine wässrige Lösung mit Tensiden gut geeignet ist. In diesem Fall wird das Orientierungsschichtmaterial emulgiert. Befindet sich unter der elastischen Orientierungsschicht noch eine unelastische $SiO_2$-Barriereschicht, wird diese in der beschriebenen Weise mechanisch zerstört.

Beispiel 2:

Ein strukturiert belichtetes Substrat mit einer Elektrodenschicht und einer Fotolackschicht wurde ganz in ein Ultraschallbad mit einer üblichen alkalischen Lösung zum Entwickeln der teilweise belichteten Fotolackschicht eingetaucht. Auf den Boden des Bades wurde zuvor eine 1 mm dicke Silikongummimatte gelegt, da sich herausstellte, daß andernfalls unscharfe Fotolackränder erhalten werden.

Beispiel 3:

Nach dem Entwickeln der Fotolackschicht gemäß Beispiel 2 wurde die Substratplatte in ein Kalziumchlorid-Salzsäure-Ultraschallbad eingetaucht. Die Badflüssigkeit wurde aus bei Zimmertemperatur gesättigter Kalziumchloridlösung mit 5 % Salzsäure hergestellt. Ultraschall relativ geringer Intensität wurde wiederum dadurch bereitgestellt, daß auf den Boden eines üblichen Ultraschallbades eine 1 mm dicke Silikongummimatte gelegt wurde. Der Ätzvorgang von ITO erfolgte bei 55 °C etwa viermal so schnell wie mit üblicher 18,5 %iger Salzsäure bei derselben Temperatur.

Besonders sauber berandete ITO-Ränder wurden dann erhalten, wenn die Viskosität der Badflüssigkeit durch Zusetzen von 20 Gew.% Orthophosphorsäure erhöht wurde. Es stellte sich heraus, daß die Menge und die Art der Phosphorsäure relativ unkritisch ist, solange die Menge nicht zu gering ist. Auch mit 30 - 50 %iger Orthophosphorsäure ohne weitere Zusätze wurden sehr gute Ätzergebnisse bei höherer Temperatur (ca. 100 °C) erzielt.

Das viskositätserhöhende Mittel sorgt insbesondere dafür, daß es kaum zu einem Unterätzen der abdeckenden Fotolackstreifen kommt. Dies ermöglicht es, sehr dicht liegende, sauber berandete Elektroden herstellen zu können. Der Vorteil des verringerten Unterätzens aufgrund erhöhter Viskosität der Ätzflüssigkeit wirkt sich auch dann aus, wenn statt ITO als Material für die Elektrodenschicht ein anderes Material eingesetzt wird.

Als viskositätserhöhendes Mittel muß nicht notwendigerweise Phosphorsäure verwendet werden. Auch beliebige Ionen, die keinen Einfluß auf die spätere Funktion der Flüssigkristallzelle haben, können eingesetzt werden. Als Komplexbildner für ITO sind Chloridionen besonders geeignet, jedoch kommt auch Weinsäure in Frage, allerdings nur in schwach saurer Lösung. Es läßt sich dann aber kaum ein Erhöhen der Ätzgeschwindigkeit feststellen.

Beispiel 4:

Die im Ultraschallbad gemäß Beispiel 3 verwendete Ätzflüssigkeit mit Chloridionen und mit Orthophosphorsäure wurde auch in einem üblichen Sprühverfahren zum Ätzen von ITO-Strukturen verwendet. Auch hier stellte sich ein erhebliches Erhöhen der Ätzgeschwindigkeit aufgrund der Komplexbildung durch die Chloridionen und ein verringertes Unterätzen aufgrund der Viskositätserhöhung durch die Orthophosphorsäure heraus.

Es wird darauf hingewiesen, daß gemäß den Beispielen 3 und 4 der Komplexbildner und das viskositätserhöhende Mittel gemeinsam angewendet wurden. Andere Versuche zeigten aber, daß die Wirkungen dieser beiden Mittel völlig unabhängig voneinander sind.

Beispiel 5:

Eine mit Kupfer beschichtete Leiterplatte wurde in üblicher Weise mit einem strukturierten Fotolackmuster versehen. Dann wurde die Leiterplatte in einem Ultraschallbad mit einer 40°C warmen Lösung von 10 Gew% Natriumpersulfat ($Na_2SO_5$) in Wasser entwickelt. Wie bei den Beispielen 2 und 3 mußte eine etwa 1 mm dicke Silikongummimatte auf den Boden des Bades gelegt werden, um die Ultraschallenergie so weit abzudämpfen, daß die durch Fotolack abgedeckten Schichtbereiche nicht beschädigt wurden.

**Ansprüche**

1. Verfahren zum Entfernen von Schichten von einem Substrat, **dadurch gekennzeichnet**, daß das Substrat mit den zu entfernenden Schichtbereichen der Behandlung in einem Ultraschallbad solcher Intensität ausgesetzt wird, daß nur die zu entfernende Schicht angegriffen wird.

2. Verfahren nach Anspruch 1, **dadurch gekennzeichnet**, daß zum Entfernen unelastischer Schichten, die durch elastische Schichten bedeckt sind, als Badflüssigkeit eine solche verwendet wird, die die elastische Schicht löst.

3. Verfahren nach Anspruch 1, **dadurch gekennzeichnet**, daß das Substrat in solchen Bereichen gedämpft gehalten wird, in denen kein Material zu entfernen ist.

4. Verfahren nach Anspruch 1, **dadurch gekennzeichnet**, daß zum strukturierten Ätzen von Schichten eine Badflüssigkeit verwendet wird, die die zu entfernenden Schichtbereiche löst, und daß Ultraschall so geringer Intensität eingesetzt wird, daß zu verbleibende Schichten nicht angegriffen werden.

5. Verfahren zum strukturierten Entfernen einer ITO-Schicht von einem Substrat für eine Flüssigkristallzelle, insbesondere Verfahren nach Anspruch 1, **dadurch gekennzeichnet**, daß als Entwicklungsflüssigkeit eine solche verwendet wird, die Komplexbilder für Indium und Zinn enthält.

6. Verfahren nach Anspruch 5, **dadurch gekennzeichnet**, daß als Entwicklungsflüssigkeit eine wässrige Salzsäure-Chlorid-Lösung verwendet wird.

7. Verfahren nach Anspruch 1, **dadurch gekennzeichnet**, daß zum strukturierten Entfernen einer Kupferschicht auf einer Leiterplatte eine wässrige Natriumpersulfatlösung verwendet wird.

8. Verfahren zum strukturierten Entfernen einer Schicht von einem Substrat, insbesondere Verfahren nach Anspruch 1 oder nach Anspruch 5, **dadurch gekennzeichnet**, daß als Entwicklungsflüssigkeit eine solche verwendet wird, die ein viskositätserhöhendes Mittel enthält.

9. Verfahren nach Anspruch 8, **dadurch gekennzeichnet**, daß als viskositätserhöhendes Mittel Phosphorsäure verwendet wird.